**Europäisches Patentamt**

**European Patent Office**

**Office européen des brevets**

(19)

(11) Veröffentlichungsnummer : **0 240 580 B2**

(12) **NEUE EUROPÄISCHE PATENTSCHRIFT**

(45) Veröffentlichungstag der neuen Patentschrift :
**17.11.94 Patentblatt 94/46**

(51) Int. Cl.$^5$ : **H04Q 3/68, H05K 7/14**

(21) Anmeldenummer : **86104544.1**

(22) Anmeldetag : **03.04.86**

(54) **Dreistufige Koppelanordnung.**

(43) Veröffentlichungstag der Anmeldung :
**14.10.87 Patentblatt 87/42**

(45) Bekanntmachung des Hinweises auf die
Patenterteilung :
**03.07.91 Patentblatt 91/27**

(45) Bekanntmachung des Hinweises auf die
Entscheidung über den Einspruch :
**17.11.94 Patentblatt 94/46**

(84) Benannte Vertragsstaaten :
**AT BE DE FR GB IT NL SE**

(56) Entgegenhaltungen :
**EP-A- 0 171 231**
**EP-A- 0 191 902**
**DE-A- 2 500 939**

(56) Entgegenhaltungen :
**DE-A- 2 542 579**
**DE-C- 2 317 798**
**DE-U-07 215 350**
**COMMUTATION ET ELECTRONIQUE, Nr. 49,**
**April 1975, Seiten 23-34, Paris, FR; P. VOYER**
**et al.: "Réseau de connexion pour grands**
**centres temporels"**
**TELCOM REPORT, Band 6, Nr. 2, April 1983,**
**Seiten 63-68, Passau, DE; B. SCHAFFER:**
**"BIGFON-Vermittlungs- und Verteiltechnik"**

(73) Patentinhaber : **ANT Nachrichtentechnik**
**GmbH**
**Gerberstrasse 33**
**D-71522 Backnang (DE)**

(72) Erfinder : **Schomers, Josef, Dipl.-Ing.**
**Villinger Strasse 12**
**D-7150 Backnang (DE)**

EP 0 240 580 B2

## Beschreibung

Die Erfindung betrifft eine dreistufige Koppelanordnung in Raumvielfachtechnik für die elektrische Nachrichtenvermittlungstechnik.

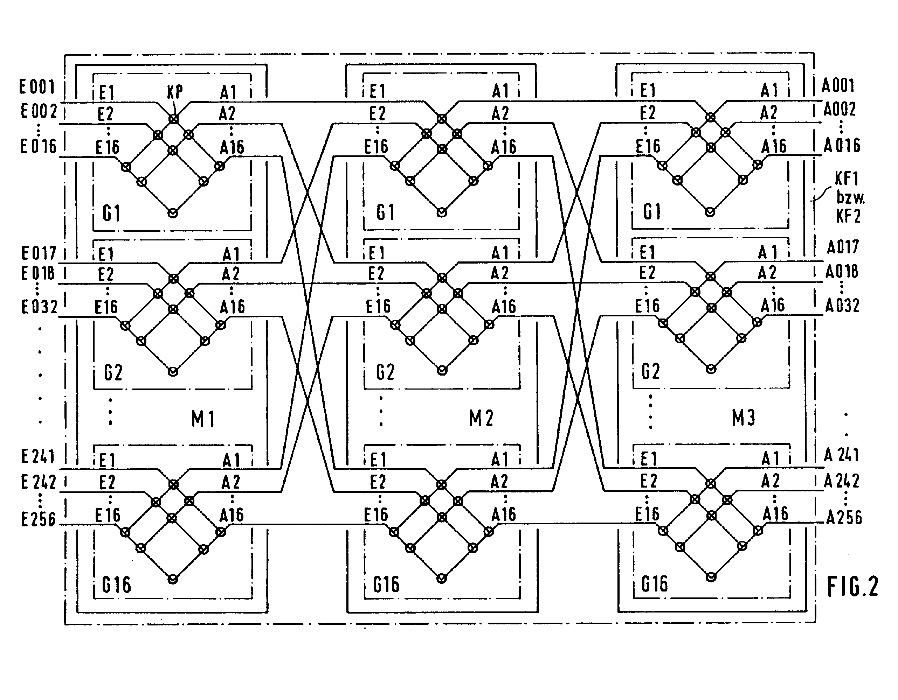

Koppelanordnungen werden verwendet, um Signalquellen wahlweise mit Signalsenken zu verbinden. Es gibt ein- und mehrstufige Koppelanordnungen. Eine dreistufige Koppelanordnung ist aus der Figur 2 und dem zugehörigen Text des Aufsatzes von Charles Clos: "A Study of Non-Blocking Switching Networks" auf den Seiten 406 bis 424 der US-Zeitschrift: The Bell System Technical Journal", Volume XXII, 1953 bekannt.

Die dort in der Figur 2 abgebildete Koppelanordnung weist eine erste Stufe, stage (a), eine zweite Stufe, stage (b), und eine dritte Stufe, stage (c) auf. Jede Stufe ist aus mehreren Koppelmatrizen aufgebaut. Die Koppelmatrizen einer Stufe unterscheiden sich in der Anzahl ihrer Ein- und Ausgänge von denen der anderen Stufen. So weisen die der ersten Stufe 6 Eingänge und 11 Ausgänge, die der zweiten Stufe 6 Eingänge und 6 Ausgänge und die der dritten Stufe 11 Eingänge und 6 Ausgänge auf. Es sind also drei verschiedene Ausführungen von Koppelmatrizen erforderlich. Die Zahl der Ausführungen ermäßigt sich auf zwei, wenn man für die Koppelpunkte solche Schaltmittel verwendet, die eine Signalübertragung in beiden Richtungen ermöglichen, wie es z.B. bei metallischen Kontakten der Fall ist. Es kann dann die für die erste Stufe vorgesehene Ausführung unter Vertauschung der Ein- und Ausgänge auch in der dritten Stufe verwendet werden.

Die Ausgänge einer jeden Koppelmatrix der ersten und zweiten Stufe sind über systematisch geführte Zwischenleitungen mit den Eingängen der Koppelmatrizen der zweiten bzw. dritten Stufe verbunden. Die Systematik dieser Zwischenleitungsführung ist folgende:

Die Ordnungszahl eines Ausganges bzw. eines Einganges ist gleich der Ordnungszahl der Koppelmatrix, mit der dieser Eingang bzw. Ausgang verbunden ist.

Diese Koppelanordnung ist blockierungsfrei. Das bedeutet, daß bei jeder möglichen Kombination von schon bestehenden Verbindungen zwischen je einer Signalquelle und je einer Signalsenke jede zusätzliche, allein aufgrund der noch freien Ein- und Ausgänge sinnvolle Verbindung auch tatsächlich durchgeschaltet werden kann. Dies gelingt, ohne daß das sogenannte "Umkoppeln", auch "Rearrangement" genannt, notwendig ist.

Irgendwelche Angaben über den mechanischen Aufbau der Koppelmatrizen und der ganzen Koppelanordnung werden nicht gemacht. Nachteilig ist, daß verschiedene Ausführungen von Koppelmatrizen erforderlich sind, was die Herstellung erschwert.

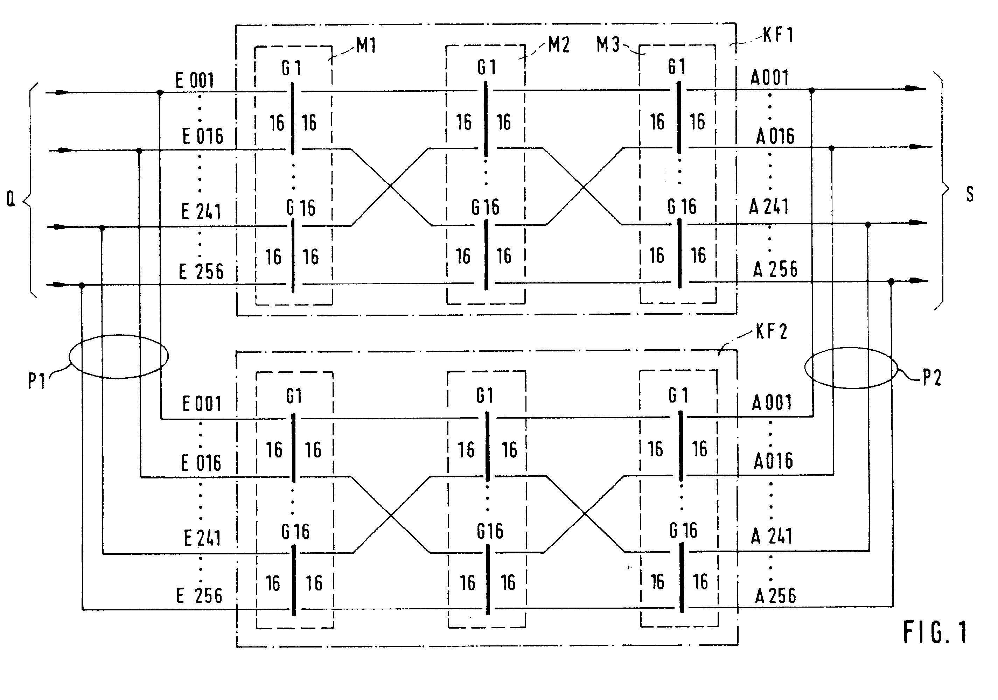

Aus den Zeilen 30 bis 46 in der Spalte 4 sowie aus der Figur 1 der deutschen Patentschrift 23 17 798 ist eine ebenfalls blockierungsfreie Koppelanordnung bekannt. Sie besteht aus zwei gleich ausgebildeten dreistufigen Koppelfeldern. Jede Stufe eines jeden Koppelfeldes weist die gleiche Anzahl von Koppelmatrizen auf. Die Zahl der Eingänge einer jeden Koppelmatrix ist gleich der Zahl ihrer Ausgänge. Ein einzelnes Koppelfeld ist jedoch nicht blockierungsfrei. Eine blockierungsfreie Koppelanordnung wird dadurch gebildet, daß zwei solche Koppelfelder parallel geschaltet werden, d.h., die Eingänge des ersten Koppelfeldes sind mit den Eingängen des zweiten Koppelfeldes verbunden. Sinngemäß sind die Ausgänge der zwei Koppelfelder miteinander verbunden.

Die Koppelmatrizen einer Stufe sind mit den Koppelmatrizen der nächsten Stufe verbunden. Nach welcher Systematik diese Verbindungen ausgeführt sind, wird nicht gelehrt. Es wird auch nichts über den mechanischen Aufbau gelehrt.

Der Erfindung liegt die Aufgabe zugrunde, eine dreistufige und blockierungsfreie Koppelanordnung anzugeben, die sich wirtschaftlich vorteilhaft herstellen läßt.

Diese Aufgabe wird durch eine Koppelanordnung nach dem Patentanspruch 1 gelöst.

Aus der deutschen Gebrauchsmusterschrift 72 15 350 ist folgender mechanischer Aufbau eines Gerätes der elektrischen Nachrichtentechnik an sich bekannt: Die einzelnen Baugruppen sind als Steckbaugruppen ausgebildet, welche an einer Kante Steckverbinder zum Herausführen von Ein- und Ausgängen tragen. Mehrere solcher Steckbaugruppen sind in einem Magazin zusammengefaßt. Das Magazin weist eine nur ihm zugeordnete Rückwandleiterplatte auf. Sie weist Gegensteckverbinder auf, in die die Steckverbinder der Steckbaugruppen eingreifen. Sie weist ferner Leiterbahnen auf, die die Gegensteckverbinder untereinander verbinden. Größere Geräte bestehen aus mehreren solchen Magazinen, die elektrisch untereinander durch Kabelbäume verbunden sind. Diese Kabelbäume werden in personalaufwendiger und damit teuren und unwirtschaftlicher Handarbeit hergestellt, wobei sich Fehler einschleichen können. Wegen dieser Handarbeit ist ferner die Lage der einzelnen Drähte in den Kabelbäumen von Exemplar zu Exemplar unterschiedlich. Das hat zur Folge, daß ihre elektrischen Eigenschaften, besonders die Nebensprechdämpfung zwischen zwei Drähten oder Drahtpaaren, ebenfalls unterschiedlich und nicht vorhersehbar ist. Dies schränkt die Verwendbarkeit von Kabelbäumen bei Nachrichtensignalen mit höheren Frequenzen ein.

In der Zeitschrift COMMUTATION ET ELECTRONIQUE, Nr. 49, April 1975, Seiten 23 bis 34, P. VOYER

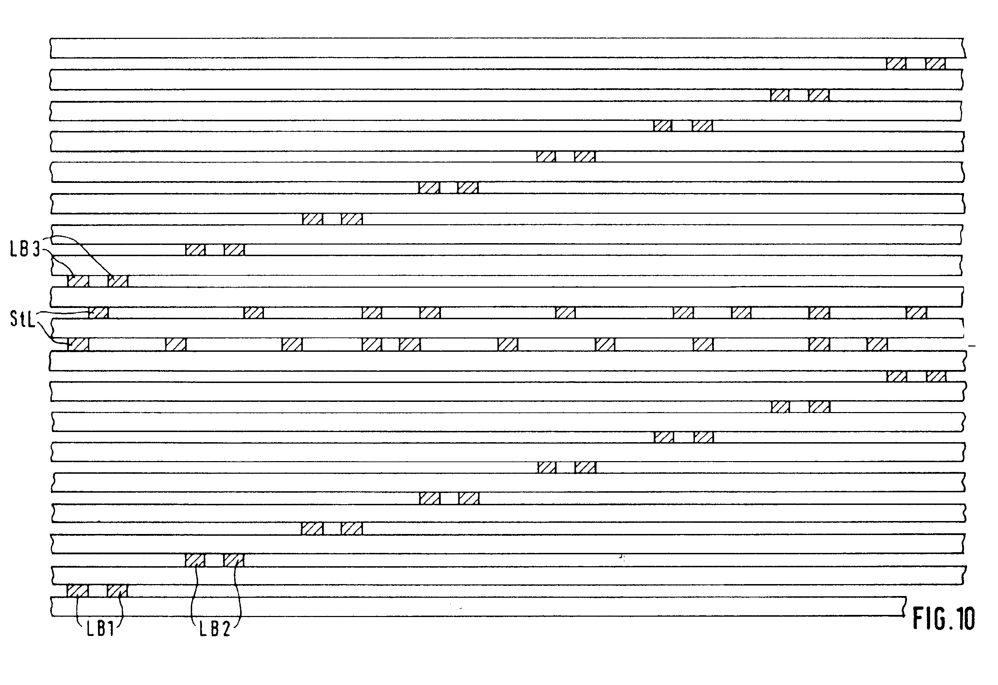

et al.: "Réseau de connexion pour grands centres temporels" ist eine Koppelanordnung nach dem Zeitvielfachprinzip beschrieben. Aus der Figur 10 ist es an sich bekannt, Eingänge eines ersten Koppelfeldes mit den Eingängen eines zweiten Koppelfeldes und Ausgänge des ersten Koppelfeldes mit Ausgängen des zweiten Koppelfeldes zu verbinden.

Aus der Zeitschrift TELECOM REPORT, Band 6, Nr. 2, April 1983, Seiten 63 bis 68, B. SCHAFFER: "BIGFON-Vermittlungs- und Verteiltechnik", Bild 4c ist ein dreistufiges Koppelfeld an sich bekannt, bei welchem jede Stufe die gleiche Zahl von Koppelmatrizen aufweist und wobei die Zahl der Eingänge einer jeden Koppelmatrix gleich der Zahl ihrer Ausgänge ist. Jedoch ist dieses Koppelfeld nicht blockierungsfrei.

Aus der DE-A-2 500 939 ist es an sich bekannt, für eine aus mehreren Baugruppen bestehende Koppelanordnung eine gemeinsame Steuerung vorzusehen, wobei die Leitungen für die den durchzuschaltenden Koppelpunkt kennzeichnenden Adressen von der Steuerung parallel zu den Baugruppen geführt sind und wobei mehrere individuell von mehreren Ausgängen der Steuerung für die Baugruppenadressen zu den jeweiligen Eingängen der Baugruppen geführte Leitungen vorgesehen sind.

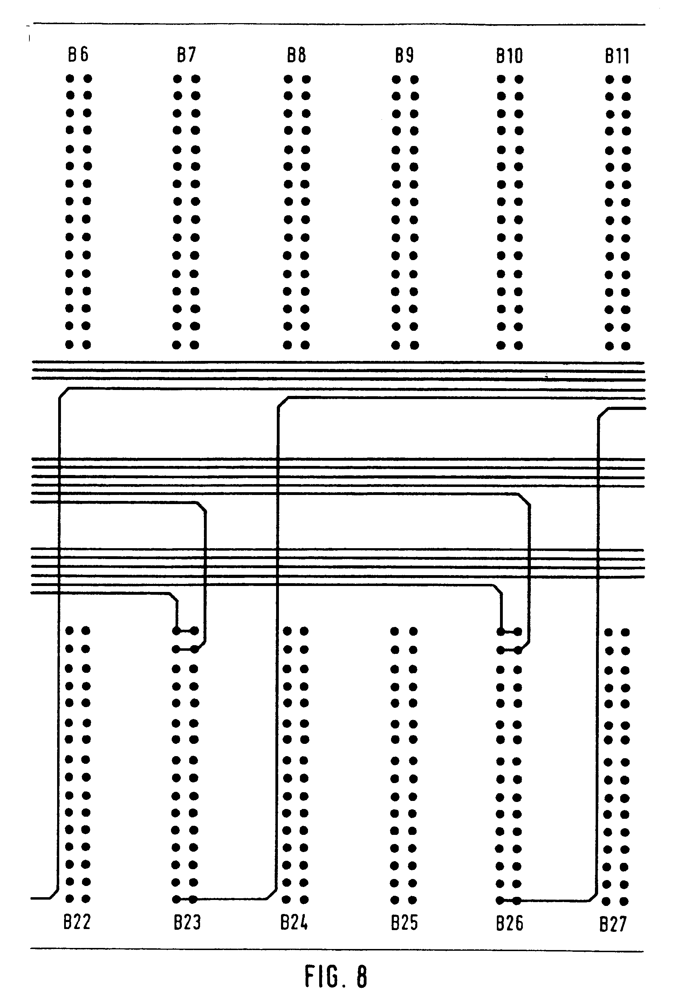

Die Erfindung wird anhand der Figuren 1 bis 15 beschrieben, wobei die Figuren 1 bis 9 ein Ausführungsbeispiel gemäß dem Patentanspruch 1 betreffen. Anhand der Figuren 10 bis 15 wird eine vorteilhafte Ausgestaltung beschrieben.

Es wird zunächst die Figur 1 beschrieben, welche ein Blockschaltbild der erfindungsgemäßen Koppelanordnung darstellt. Die Koppelanordnung besteht aus einem ersten und einem zweiten, gleichartigen Koppelfeld KF1 bzw. KF2. Jedes Koppelfeld besteht aus einer ersten, einer zweiten und einer dritten Stufe M1, M2 bzw. M3, ist also dreistufig ausgebildet. Jede Stufe enthält 16 gleichartige Koppelmatrizen G1 bis G16, wobei jede 16 Eingänge und 16 Ausgänge aufweist.

Jeder Eingang einer Koppelmatrix der ersten Stufe bildet einen Eingang des betreffenden Koppelfeldes. Bei 16 Koppelmatrizen G1 bis G16 mit je 16 Eingängen ergeben sich so 256 Eingänge E001 bis E256 des Koppelfeldes KF1 bzw. KF2. In der gleichen Weise bilden die Ausgänge der Koppelmatrizen der dritten Stufe die 256 Ausgänge A001 bis A256.

Über eine erste Parallelverkabelung P1 ist jeder der Eingänge E001 bis E256 des ersten Koppelfeldes KF1 mit dem gleichnamigen Eingang des zweiten Koppelfeldes verbunden. In der gleichen Weise sind über eine zweite Parallelverkabelung P2 die Ausgänge A001 bis A256 verbunden. Auf diese Weise sind die beiden Koppelfelder KF1 und KF2 parallel geschaltet. Es sind ferner 256 Signalquellen Q mit den Eingängen E001 bis E256 und 256 Signalsenken S mit den Ausgängen A001 bis A256 verbunden.

Es wird nun die Figur 2 beschrieben. Sie stellt ein Blockschaltbild des ersten bzw. zweiten Koppelfeldes KF1 bzw. KF2 dar. Es sind wieder die erste, zweite und dritte Stufe M1, M2 und M3 und die sie bildenden Koppelmatrizen G1 bis G16 dargestellt. Jede Koppelmatrix besteht aus 256, in einer 16x16-Matrix angeordnete Koppelpunkte KP. Es sind ferner die Eingänge E1 bis E16 und die Ausgänge A1 bis A16 einer jeden Koppelmatrix angegeben.

Es ist weiterhin dargestellt, wie die Eingänge E1 bis E16 der Koppelmatrizen der ersten Stufe M1 bis 256 Eingänge E001 bis E256 des Koppelfeldes KF1 bzw. KF2 und die Ausgänge A1 bis A16 der Koppelmatrizen der dritten Stufe M3 die 256 Ausgänge A001 bis A256 des Koppelfeldes KF1 bzw. KF2 bilden.

Die Ausgänge A1 bis A16 einer jeden Koppelmatrix G1 bis G16 der ersten und der zweiten Stufe M1, M2 sind über systematisch geführte Zwischenleitungen mit den Eingängen E1 bis E16 der Koppelmatrizen G1 bis G16 der zweiten bzw. dritten Stufe M2 bzw. M3 verbunden. Die Systematik dieser Zwischenleitungsführung ist die gleiche wie bei der eingangs beschriebenen Koppelanordnung nach Charles Clos.

Bei dem hier beschriebenen Ausführungsbeispiel bedeutet dies, daß, wie in der Figur 2 dargestellt, verbunden sind:

a) Alle ersten Ausgänge, also A1, der Koppelmatrizen in der ersten Stufe M1 mit der ersten Koppelmatrix, also G1, der zweiten Stufe, alle zweiten Ausgänge mit der zweiten Koppelmatrix usw.

b) Alle ersten Eingänge, also E1, der Koppelmatrizen in der zweiten Stufe M2 mit der ersten Koppelmatrix, also G1, der ersten Stufe, alle zweiten Eingänge mit der zweiten Koppelmatrix usw..

Die unter a) und b) angegebenen Verbindungen gelten sinngemäß auch für die Zwischenleitungsführung zwischen der zweiten und dritten Stufe.

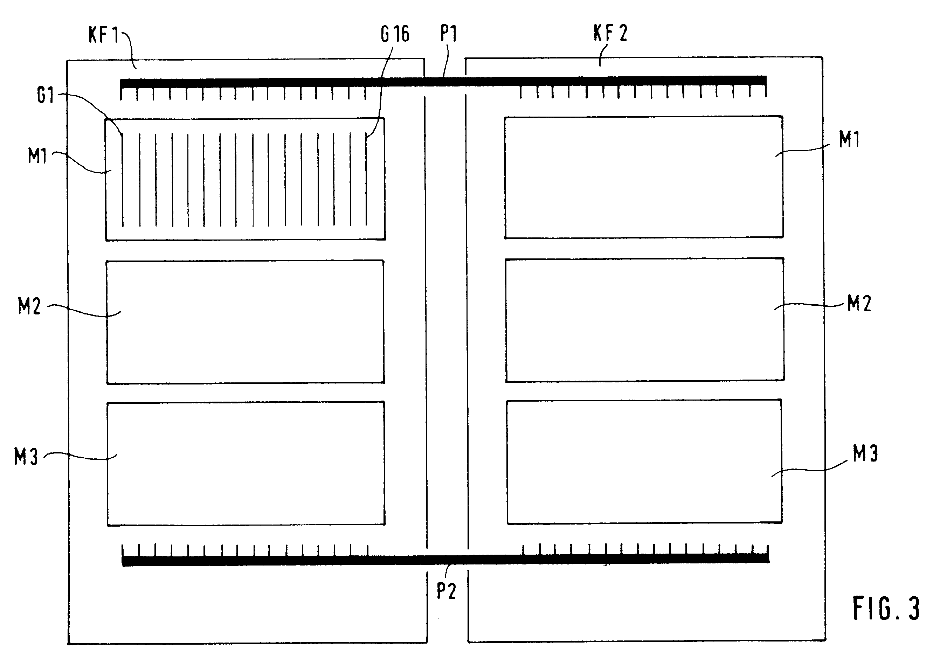

Anhand der Figur 3 wird der mechanische Aufbau beschrieben. Es sind zwei Schränke vorgesehen, für jedes Koppelfeld einer. Um diese Zuordnung zu verdeutlichen, wurden die Schränke mit den entsprechenden Bezugszeichen KF1 bzw. KF2 der Koppelfelder bezeichnet. Jeder Schrank enthält ein erstes, ein zweites und ein drittes Magazin M1, M2 und M3. Jedes Magazin enthält die 16 Koppelmatrizen G1 bis G16 einer Stufe. Durch die gleichlautenden Bezugszeichen M1, M2 bzw. M3 für die Magazine einerseits und die Stufen in den Figuren 1 und 2 ist die jeweilige Zuordnung angegeben.

Jede Koppelmatrix ist als Steckbaugruppe ausgebildet. Da gemäß den Figuren 1 oder 2 jede Stufe 16 Koppelmatrizen umfaßt, enthält auch jedes Magazin 16 Steckbaugruppen. Im ersten Magazin M1 des ersten

3

Schrankes KF1 sind diese 16 Steckbaugruppen eingezeichnet, wobei die erste mit G1 und die letzte mit G16 bezeichnet wurde. Durch die Wahl der gleichen Bezugszeichen G1 bis G16 wird wieder die Zuordnung zu den in den Figuren 1 und 2 gezeichneten Koppelmatrizen angegeben. Mit P1 und P2 wurde die erste bzw. zweite Parallelverkabelung bezeichnet.

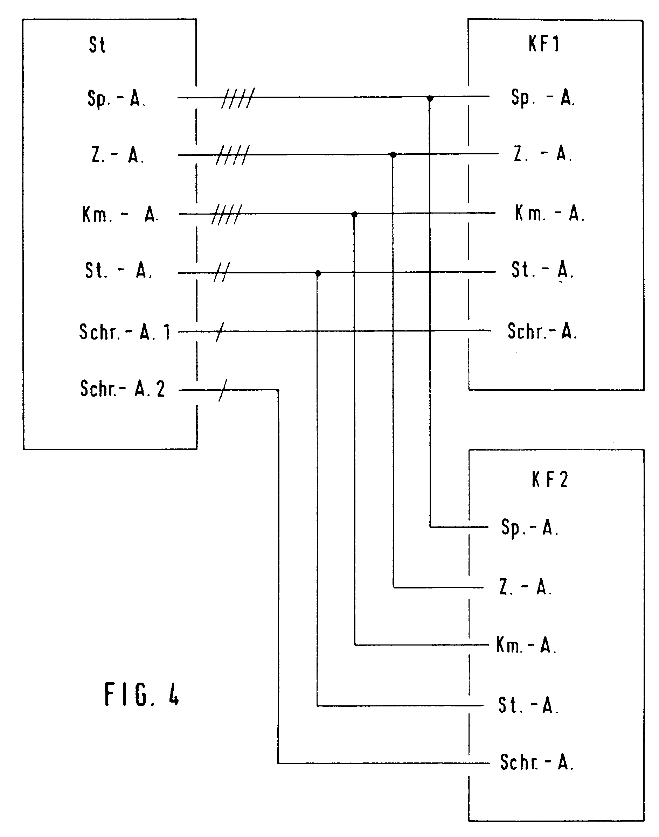

Anhand der Figur 4 wird die Steuerung der zwei Koppelfelder KF1 und KF2 durch eine gemeinsame Steuerung St gezeigt. Diese Steuerung weist je vier Ausgänge für die den durchzuschaltenden Koppelpunkt kennzeichnenden Adressen, nämlich für die Spalten-Adresse Sp.-A., für die Zeilen-Adresse Z.-A. und für die Koppelmatrix-Adresse Km.-A. sowie zwei Ausgänge für die Stufen-Adresse St.-A., auf. Diese Ausgänge sind über jeweils vier bzw. zwei Drähte mit den gleichnamigen Eingängen der Koppelfelder KF1 und KF2 verbunden. Da jede Koppelmatrix entsprechend ihren 16 Ein- und 16 Ausgängen 16 Spalten und 16 Zeilen aufweist, jede Stufe 16 Koppelmatrizen enthält und jedes Koppelfeld 3 Stufen aufweist, genügen bei Anwendung der binären Kodierung zur eindeutigen Kennzeichnung eines durchzuschaltenden Koppelpunktes diese jeweils vier Drähte für die Spalten-, Zeilen- und Koppelmatrix-Adresse und die zwei Drähte für die Stufen-Adresse. Die Kennzeichnung des jeweiligen Schrankes bzw. Koppelfeldes KF1 oder KF2 geschieht über die einzeln geführten Drähte, welche die zwei Ausgänge Schr.-A.1 und Schr.-A.2 für die Schrank-Adressen mit den entsprechenden Eingängen Schr.-A. in den Koppelfeldern KF1 bzw. KF2 verbinden.

Jedes der Koppelfelder KF1 und KF2 alleine ermöglicht schon eine Verbindung eines jeden Einganges mit jedem beliebigen Ausgang. Jedoch können Blockierungen auftreten, d.h., wenn schon mehrere Verbindungen bestehen, kann eine weitere, von einem bestimmten Eingang zu einem bestimmten Ausgang zu führende Verbindung nicht mehr durchgeschaltet werden. Durch die Parallelschaltung zweier solcher Koppelfelder werden diese Blockierung vermieden, so daß also die erfindungsgemäße Koppelanordnung blockierungsfrei ist.

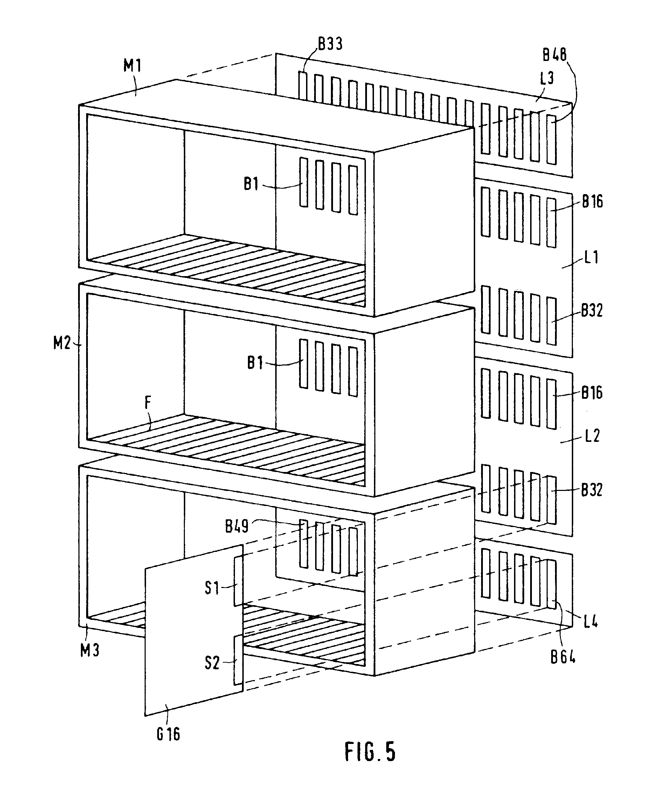

Der mechanische Aufbau eines einzelnen Koppelfeldes KF1 oder KF2 wird anhand der Figuren 5 bis 9 beschrieben.

Es wird zunächst die Figur 5 betrachtet. Sie zeigt wieder die drei Magazine M1 bis M3, und zwar hier ihre mechanische Anordnung übereinander. Das erste Magazin M1 befindet sich oben, darunter ist das zweite Magazin M2 und ganz unten das dritte Magazin M3 angeordnet. Sie sind in nicht dargestellter Weise mechanisch miteinander verbunden. Das zweite Magazin ist also sowohl dem ersten als auch dem dritten benachbart.

Jedes Magazin weist oben und unten je 16 Führungsleisten F auf, in die die Steckbaugruppen geführt werden. Es sind nur die unteren Führungsleisten sichtbar. Von den 48 Steckbaugruppen (16 je Magazin) ist nur die sechzehnte Steckbaugruppe G16 des dritten Magazins M3 dargestellt. Jede Steckbaugruppe trägt als Steckverbinder eine erste und eine zweite Steckerleiste S1 bzw. S2. Statt der zwei Steckerleisten S1 und S2 kann auch eine einzige, große Steckerleiste vorgesehen sein.

Ferner ist eine erste und eine zweite Rückwandleiterplatte L1 bzw. L2 dargestellt. Jede trägt als Gegensteckverbinder zwei Reihen von je 16 Buchsenleisten, wobei die Buchsenleisten B1 bis B16 die obere Reihe und die Buchsenleisten B17 bis B32 die untere Reihe bilden. Die Buchsenleiste B17 und einige weitere, nicht bezeichnete Buchsenleisten sind hier nicht sichtbar. Weiter sind eine dritte und eine vierte Rückwandleiterplatte L3 bzw. L4 vorgesehen. Diese tragen nur eine Reihe von je 16 Buchsenleisten B33 bis B48 bzw. B49 bis B64.

Durch gestrichelte Linien ist angedeutet, in welcher der Führungsleisten die dargestellte Steckbaugruppe G16 bei ihrem Einstecken geführt wird, welche Lage die Rückwandleiterplatten an der Rückseite der Magazine nach dem Zusammenbau einnehmen sowie daß die Steckerleisten S1 und S2 der dargestellten Steckbaugruppe G16 in die Buchsenleiste B32 der zweiten Rückwandleiterplatte L2 und die Buchsenleiste B64 der vierten Rückwandleiterplatte L4 eingreifen. In der gleichen Weise greifen die Steckerleisten der nicht dargestellten Steckbaugruppen in die ihnen zugeordneten Buchsenleisten ein.

So ergibt sich eine Zuordnung gemäß der folgenden Tabelle:

| Steckbaugruppen G1 bis G16 in Magazin | Stecker-leiste | Rückwand-leiterplatte | Buchsen-leisten |
|---|---|---|---|
| M1 | S1 | L3 | B33 bis B48 |
| | S2 | L1 | B1 bis B16 |
| M2 | S1 | | B17 bis B32 |
| | S2 | L2 | B1 bis B16 |
| M3 | S1 | | B17 bis B32 |
| | S2 | L4 | B49 bis B64 |

Falls statt der zwei Steckerleisten S1 uns S2 eine einzige große Steckerleiste vorgesehen ist, greift von ihr der jeweilige Teil gemäß obiger Tabelle in die entsprechende Buchsenleiste ein.

Die Rückwandleiterplatte L1 umfaßt also den Bereich der Steckerleisten S2 des ersten Magazins M1 und den Bereich der Steckerleisten S1 des zweiten Magazins M2. Der Bereich der Steckerleisten S2 des ersten Magazins M1 ist dem Bereich der Steckerleisten S1 des zweiten Magazins M2 benachbart. Das gleiche gilt sinngemäß für die Rückwandleiterplatte L2.

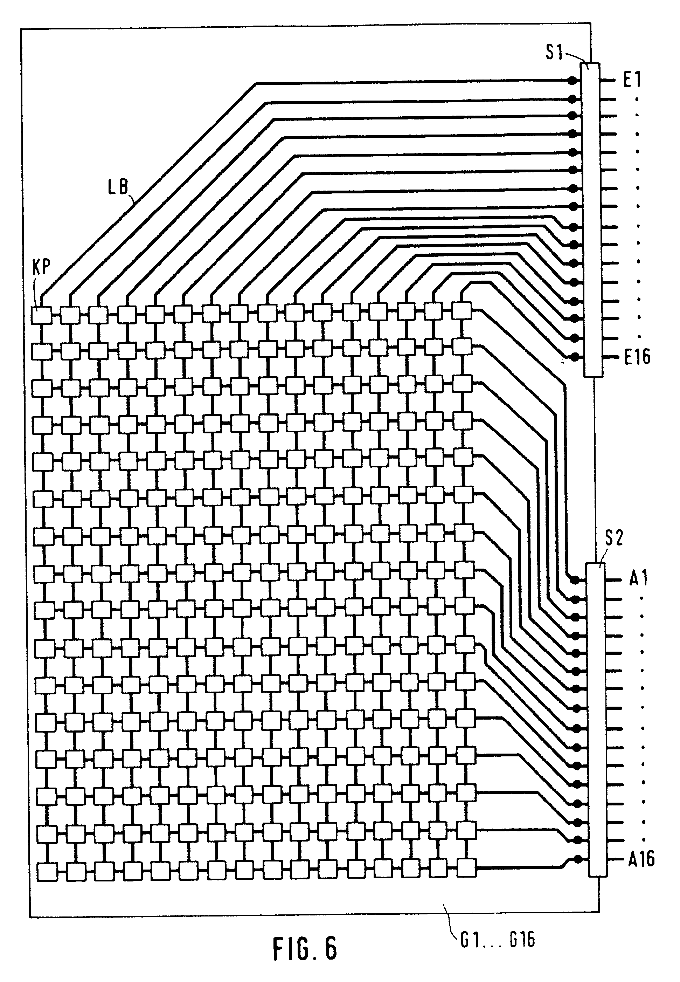

In der Figur 6 ist eine der Steckbaugruppen G1 bis G16 dargestellt. Sie besteht aus einer Leiterplatte LP, welche die 256, in einer 16x16-Matrix angeordneten Koppelpunkte KP, eine erste Steckerleiste S1 und eine zweite Steckerleiste S2 trägt. Die Leiterplatte LP weist Leiterbahnen LB auf, die die Koppelpunkte KP untereinander sowie mit den 16 Eingängen E1 bis E16 und den 16 Ausgängen A1 bis A16 auf den Steckerleisten S1 bzw. S2 verbinden. Die Eingänge E1 bis E16 sind alle auf der ersten Steckerleiste S1, die Ausgänge A1 bis A16 sind alle auf der zweiten Steckerleiste S2 herausgeführt. Wie aus der Figur 5 hervorgeht, ist bei den Steckbaugruppen des zweiten Magazins M2 die erste Steckerleiste S1 dem ersten Magazin M1 am nächsten gelegen. Deshalb sind auf ihr die Eingänge E1 bis E16 herausgeführt, weil diese gemäß der Figur 2 mit den Ausgängen der Steckbaugruppen des ersten Magazins M1 verbunden werden müssen. Das Gleiche gilt sinngemäß für die zweiten Steckerleisten S2 und für die Steckbaugruppen der anderen Magazine.

Die Leiterbahnen LB wurden hier einpolig dargestellt. Da Koppelfelder jedoch üblicherweise zwei- oder gar vieradrig ausgeführt werden, muß man sich anstelle einer Linie zwei bzw. vier Leiterbahnen und auf den Steckerleisten entsprechend viele Steckerstifte vorstellen.

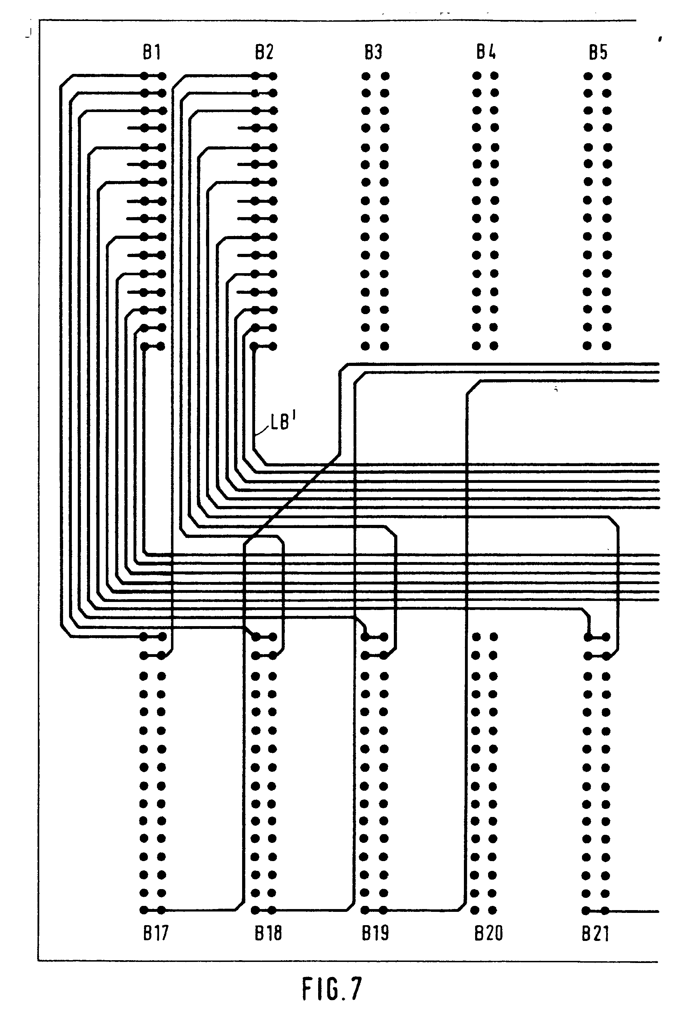

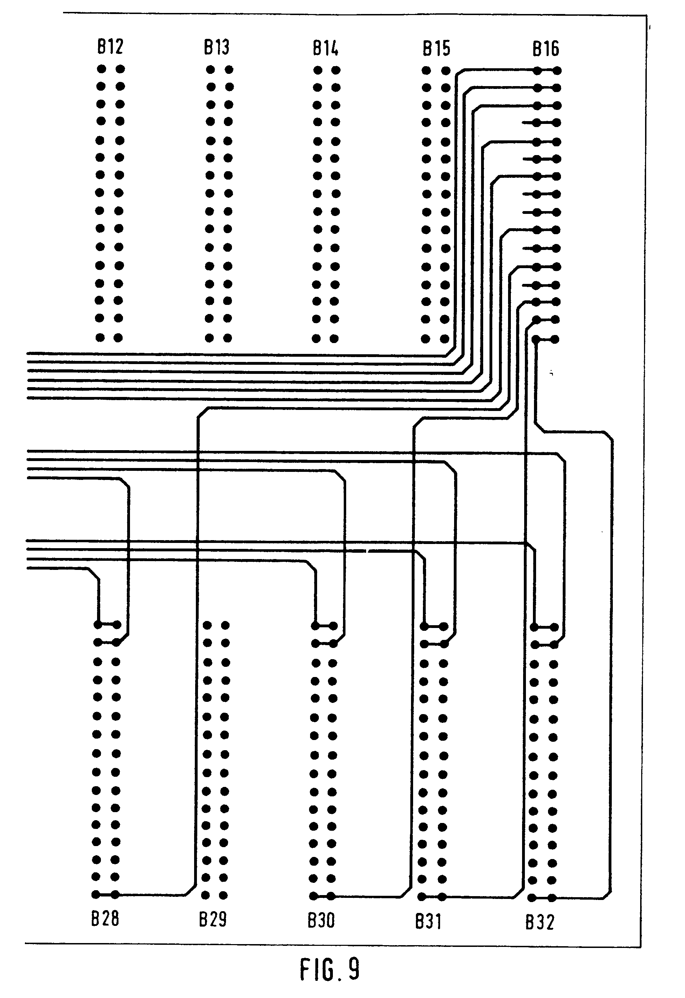

In den Figuren 7, 8 und 9 ist eine der Rückwandleiterplatten L1 bzw. L2 dargestellt. Diese Figuren lege man nebeneinander, die Figur 7 links und die Figur 9 rechts. Die jeweils obere und untere Linie sowie die linke bzw. rechte Linie auf der Figur 7 bzw. 9 geben die Umrisse dieser Rückwandleiterplatte an. Mit B1 bis B16 (obere Reihe) und B17 bis B32 sind die Plätze für die Buchsenleisten B1 bis B32 bezeichnet. Diese Buchsenleisten selbst sind dicht dargestellt, sondern es sind durch Punkte nur die Lötaugen für ihre Lötstifte angedeutet. Betrachtet man die erste Rückwandleiterplatte L1, so liegen, wie aus den Figuren 5 und 6 hervorgeht, auf den Buchsenleisten B1 bis B16 die Ausgänge A1 bis A16 der Steckbaugruppen G1 bis G16 aus dem ersten Magazin M1. auf den Buchsenleisten B17 bis B32 liegen die Eingänge E1 bis E16 der Steckbaugruppen des zweiten Magazins M2, und zwar jeweils oben mit E1 bzw. A1 beginnend.

Die Zwischenleitungen, die gemäß der Figur 2 zu schaffen sind, werden durch Leiterbahnen LB' gebildet. Dabei wurde hier wieder eine einpolige Darstellung gewählt; und man muß sich anstelle einer Linie zwei Leiterbahnen vorstellen, da, wie an der Darstellung von je zwei Lötaugen für jeden Ein- bzw. Ausgang zu erkennen ist, hier eine Rückwandleiterplatte für ein zweiadriges Koppelfeld gezeichnet ist. Von den vielen Zwischenleitungen sind hier nur einige gezeichnet. Außerdem ist nicht gezeichnet, daß die Leiterbahnen auf verschiedene Ebenen einer Multilayerplatte verteilt sind, um ihre große Zahl unterbringen und ihre Kreuzungen ausführen zu können.

Die zweite Rückwandleiterplatte ist wie die erste ausgeführt, da laut Figur 2 die Systematik der Zwischenleitungsführung zwischen der ersten und der zweiten Stufe derjenigen zwischen der zweiten und dritten Stufe gleicht.

Auf den Buchsenleisten B33 bis B48 der dritten Rückwandleiterplatte L3 liegen die 256 Eingänge E001 bis E256 und auf den Buchsenleisten B49 bis B64 der vierten Rückwandleiterplatte L4 liegen die Ausgänge A001 bis A256 des jeweiligen Koppelfeldes KF1 bzw. KF2. An den Lötstifen dieser Buchsenleisten sind die Parallelverdrahtungen P1 und P2 sowie die Verbindungen zu den Signalquellen Q und den Signalsenken S angeschlossen.

Nicht dargestellt sind Schaltmittel und Steuerleitungen zum Durchschalten und Ausschalten der Koppelpunkte. Dies gilt auch für die Steckbaugruppen.

Dadurch, daß zwei benachbarte Magazine durch eine ihnen gemeinsame Rückwandleiterplatte verbunden sind, die auch die Zwischenleitungen tragen, ist eine fehlerfreie und mit wenig Handarbeit und damit wirtschaftlich vorteilhafte Herstellung dieser Verbindung möglich.

Durch die Weiterbildung gemäß dem Patentanspruch 2 wird erreicht, daß die erfindungsgemäße Koppelanordnung zur Übertragung von Digitalsignalen mit einer Bitrate bis zu 150 MBit/s geeignet ist.

Dazu gehört, daß bei dieser hohen Bitrate noch eine ausreichend hohe Nebensprechdämpfung zwischen den Leiterbahnen einer Rückwandleiterplatte L1 bzw. L2 besteht. Wie diese hohe Nebensprechdämpfung erreicht wird, sei anhand der Figur 10 erläutert. Sie zeigt einen Schnitt durch eine solche Rückwandleiterplatte, um die Lage der Leiterbahnen in ihr darzustellen. Sie weist 19 Schichten auf, zwischen denen die schraffiert gezeichneten Leiterbahnen liegen. Es wird ein zweiadrig aufgebautes Koppelfeld angenommen, d.h., jede Verbindung ist als ein Paar von Leiterbahnen ausgeführt. Das erste Paar ist mit LB1 bezeichnet und liegt in der ersten Ebene zwischen der ersten und zweiten Schicht. Um eine ausreichend hohe Nebensprechdämpfung zu erreichen, ist das zweite Paar LB2 in der nächsten, also zweiten Ebene nicht unmittelbar neben dem ersten Paar LB1 angeordnet, sondern entsprechend der Nebensprechdämpfungsforderung seitlich versetzt. Diese Versetzung erstreckt sich über acht Ebenen. Die neunte und zehnte Ebene trägt die Leiterbahnen StL für die in den Figuren 7 bis 9 nicht dargestellten Steuerleitungen. Die gegebenen Nebensprechdämpfungsforderungen erlauben es erst, in der elften Ebene wieder ein Paar LB3 ohne Versetzung gegenüber dem ersten Paar LB1 anzuordnen.

Dazu gehört auch, daß die Leiterbahnen der Rückwandleiterplatten keine Stoßstellen aufweisen. Um solche Stoßstellen zu vermeiden, sind, wie in den Figuren 7 bis 9 zu erkennen ist, spitzwinklige Abknickungen der Leiterbahnen ganz vermieden und rechtwinklige in zwei stumpfwinklige aufgelöst. Statt der Auflösung in stumpfwinklige Abknickungen ist eine abgerundete Ausführung möglich. Dies gilt auch für die Leiterbahnen der Steckbaugruppen. Falls sich spitzwinklige Abknickungen nicht vermeiden lassen, werden sie ebenfalls in mehrere stumpfwinklige aufgelöst oder abgerundet ausgeführt.

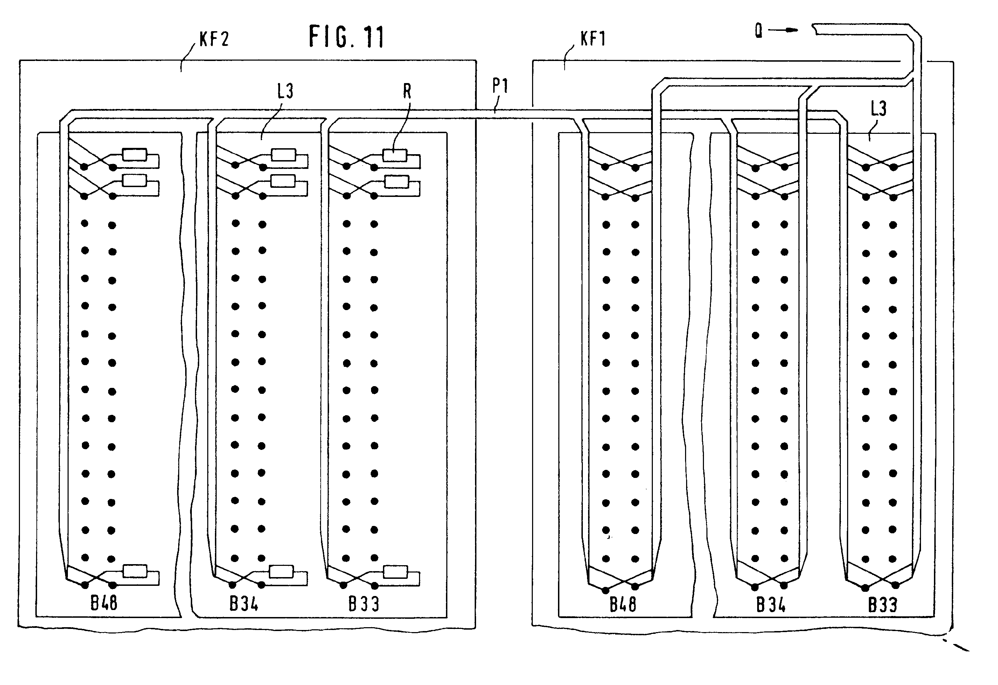

Dazu gehört ferner, daß die Signalquellen Q reflexionsfrei mit den Eingängen E001 bis E256 verbunden sind. Wie dies erreicht wird, sei anhand der Figur 11 erläutert. Es sind die zwei Schränke bzw. Koppelfelder KF1 und KF2 und die in ihnen befindlichen Rückwandleiterplatten L3 angedeutet. Die Punkte stellen die Lötstifte der Buchsenleisten B33 bis B48 dar. Ein nicht bezeichnetes Kabel führt von den Signalquellen Q zu den Buchsenleisten B33 bis B48 im ersten Schrank KF1, und die Drähte aus diesem Kabel sind an die Lötstifte dieser Buchsenleisten angelötet. Von diesen Drähten sind nur einige dargestellt. An diese Lötstifte sind ferner die Drähte der Parallelverkabelung P1 angelötet. Diese Drähte enden andererseits auf den Lötstiften der Buchsenleisten B33 bis B48 des zweiten Schrankes KF2. An diesen Lötstiften sind außerdem Widerstände R angeschlossen. Ihr Widerstandswert ist gleich dem Wellenwiderstand der Parallelverkabelung P1 und des von den Signalquellen Q kommenden Kabels gewählt. Diese Widerstände bewirken den erforderlichen reflexionsfreien Abschluß, da die Koppelmatrizen selbst, wegen ihres hohen Eingangswiderstandes einen solchen Abschluß nicht bieten können. Statt des Lötens ist auch jede andere Verbindungstechnik anwendbar. Die Widerstände R und das von den Signalquellen kommende Kabel können auch vertauscht sein, d.h. das Kabel endet im zweiten Schrank KF2 und die Widerstände R befinden sich im ersten Schrank KF1.

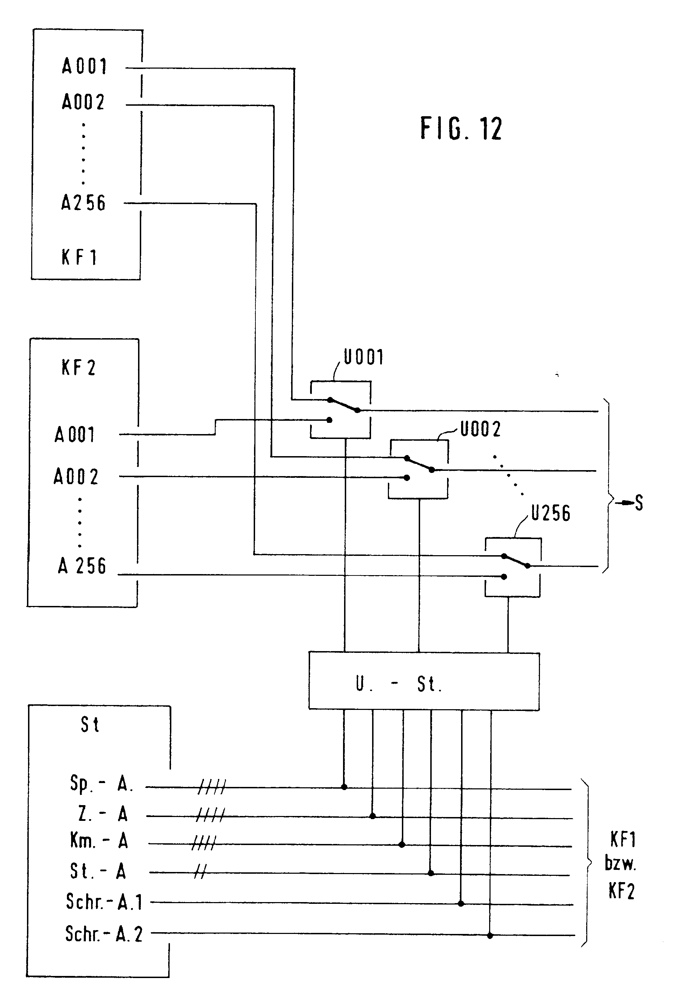

Die entsprechende Ausbildung der ausgangsseitigen Parallelverkabelung" wird anhand der Figur 12 beschrieben. Es sind die zwei Schränke KF1 und KF2 mit ihren je 256 Ausgängen A001 bis A256 sowie 256 elektronische Umschalter U001 bis U256 angedeutet. Jeder der Ausgänge A001 bis A256 ist mit dem zugehörigen ersten bzw. zweiten Eingang des zugehörigen elektronischen Umschalters U001 bis U256 verbunden. Die Ausgänge der elektronischen Umschalter sind mit den Signalsenken S verbunden. Die elektronischen Umschalter weisen ferner Steuereingänge auf, die mit einer Umschaltsteuerung U.-St. verbunden sind. So kann diese Umschaltsteuerung die elektronischen Umschalter in ihre erste oder zweite Schaltstellung steuern. Hier ist die erste Schaltstellung gezeichnet, in der der jeweilige Ausgang des ersten Koppelfeldes KF1 zur betreffenden Signalsenke S durchgeschaltet ist.

Da die Koppelmatrizen G1 bis G16 ausgangsseitig schon Abschlußwiderstände aufweisen, ist eine ausgangsseitige einfache Parallelschaltung wie bei den Eingängen nicht möglich. Vielmehr darf nur einer der betreffenden Ausgänge der Koppelfelder KF1 bzw. KF2 zu der betreffenden Signalsenke S durchgeschaltet werden. Dies bewirken die elektronischen Umschalter U001 bis U256 in Abhängigkeit davon, ob die jeweilige Verbindung über das erste Koppelfeld KF1 oder über das zweiter Koppelfeld KF2 durchgeschaltet wurde. Die dazu nötige Einstellinformation gewinnt die Umschaltsteuerung U.-St. aus der Spalten-Adresse Sp.-A., der Zeilen-Adresse Z.-A., der Koppelmatrix-Adresse Km.-A., der Stufen-Adressen St.-A. sowie den Schrank-Adressen Schr.-A.1 und Schr.-A.2. Sie ist deshalb mit den entsprechenden, in der Beschreibung der Figur 4 schon erwähnten Ausgängen der Steuerung St verbunden.

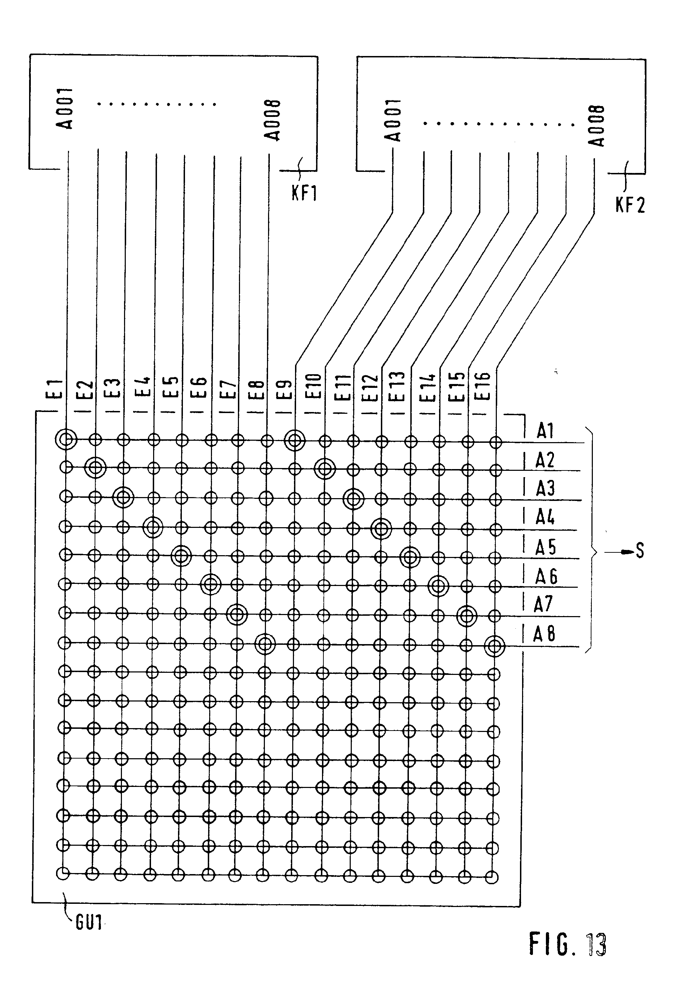

Eine vorteilhafte Ausführung der elektronischen Umschalter wird anhand der Figur 13 beschrieben. Um eine Typenvielfalt von Steckbaugruppen zu vermeiden, werden als elektronische Umschalter die gleichen Koppelmatrizen verwendet wie sie in den Koppelfeldern KF1 und KF2 eingesetzt und anhand der Figur 6 beschrieben sind. Eine solche Koppelmatrix ist auch in der Figur 13 dargestellt und dort mit GU1 bezeichnet. Es sind durch Kreise die 256 Koppelpunkte angedeutet. Die Eingänge EI bis E8 sind mit den Ausgängen A001 bis A008 des ersten Koppelfeldes KF1 verbunden. Die Eingänge E9 bis E16 sind mit den Ausgängen A001 bis A008 des zweiten Koppelfeldes KF2 verbunden. An die Ausgänge A1 bis A8 dieser Koppelmatrix sind die zugehörigen 8 Signalsenken S angeschlossen.

Die Funktion ist folgende: Soll z.B. eine Verbindung zu der am Ausgang A1 der Koppelmatrix GU1 angeschlossenen Signalsenke durchgeschaltet werden, so wird in dieser Koppelmatrix entweder der den Eingang E1 oder der den Eingang E9 mit dem Ausgang A1 verbindende Koppelpunkt durchgeschaltet, je nach dem, ob die Verbindung über das erste oder zweite Koppelfeld KF1 bzw. KF2 geführt wird. In der sinngemäß gleichen Weise wird bei einem Verbindungsaufbau zu den anderen Ausgängen verfahren. Die dazu jeweils benötigten Koppelpunkte sind in der Figur 13 durch zwei Kreise hervorgehoben.

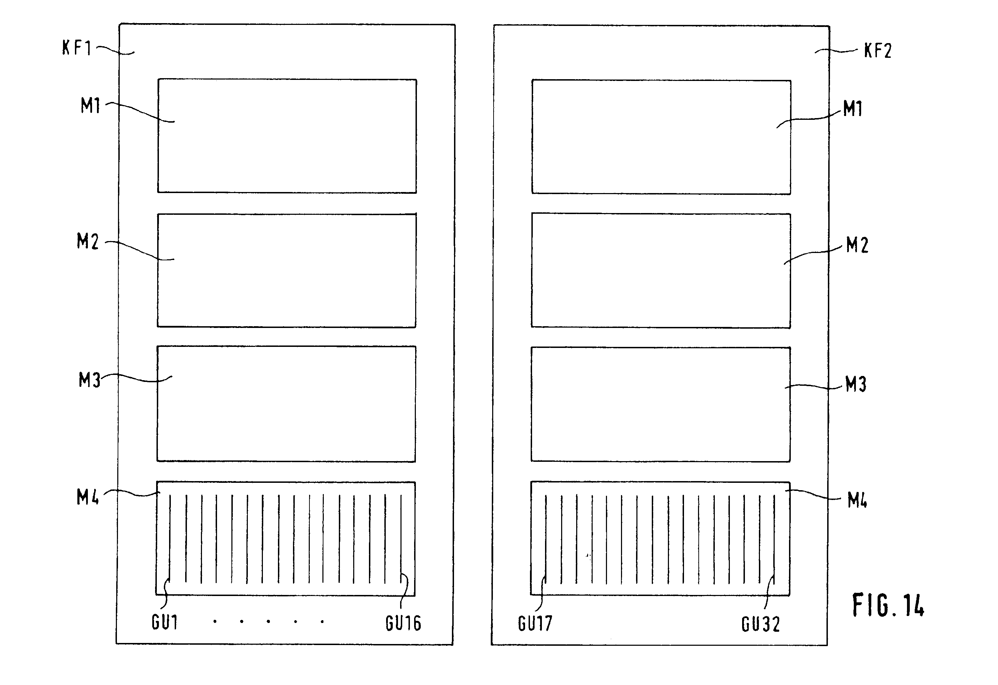

In der gleichen Weise werden die weiteren Ausgänge A009 bis A256 der Koppelfelder KF1 und KF2 zusammengeschaltet. So ergeben sich 32 solcher Koppelmatrizen. Ihre Unterbringung wird anhand der Figur 14 beschrieben. Die zwei Schränke KF1 und KF2 enthalten zusätzlich zu den Magazinen M1 bis M3 noch die vierten Magazine M4, welche die 32 Koppelmatrizen GU1 bis GU32 aufnehmen. Die Koppelmatrizen GU1 bis GU16 befinden sich im ersten Schrank KF1, die Koppelmatrizen GU17 bis GU32 befinden sich im zweiten Schrank KF2.

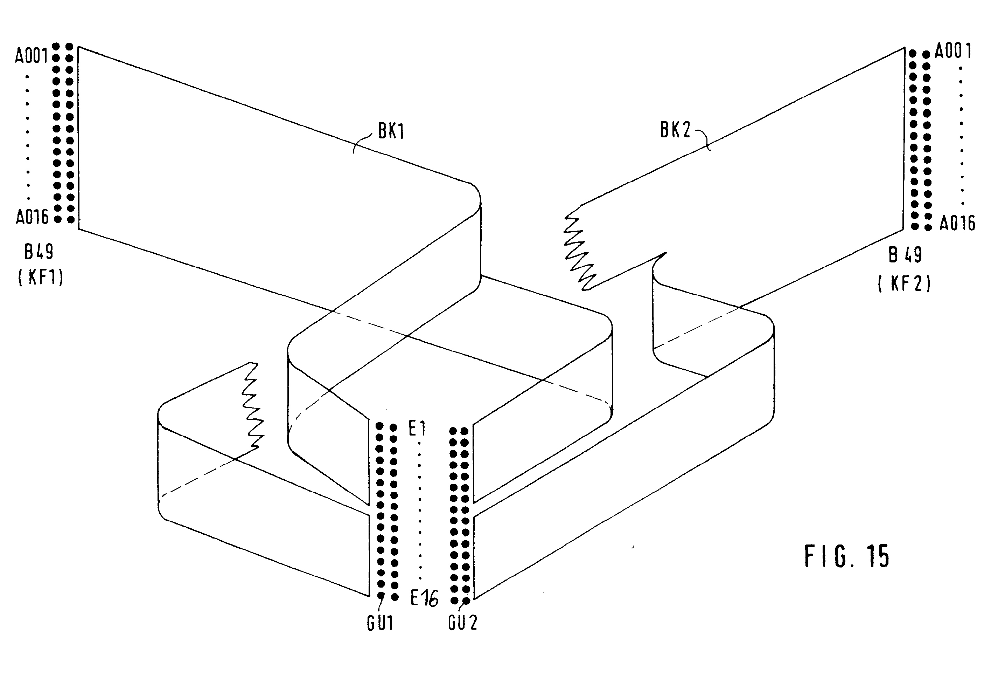

Eine vorteilhafte Verdrahtung zwischen den Ausgängen A001 bis A256 der Koppelfelder KF1 bzw. KF2 und den Eingängen E1 bis E8 der Koppelmatrizen GU1 bis GU32 wird anhand der Figur 15 beschrieben. Es sind durch jeweils 32 Punkte die Lötstifte der Buchsenleisten B49 des ersten und des zweiten Koppelfeldes KF1 bzw. KF2 dargestellt, auf denen die Ausgänge A001 bis A016 liegen. Ebenfalls durch je 32 Punkte sind die Lötstifte derjenigen Buchsenleisten dargestellt, auf denen die Eingänge E1 bis E16 der Koppelmatrizen GU1 und GU2 liegen. Es sind zwei Bandkabel BK1 und BK2 vorgesehen, wobei jedes 16 nebeneinander geführte Adernpaare aufweist. Über das erste Bandkabel BK1 sind die Ausgänge A001 bis A016 des ersten Koppelfeldes KF1 mit den Eingängen E1 bis E8 der Koppelmatrizen GU1 und GU2 verbunden. Über das zweite Bandkabel BK2 sind die Ausgänge A001 bis A016 des zweiten Koppelfeldes KF2 mit den Eingängen E9 bis E16 der Koppelmatrizen GU1 und GU2 verbunden. Die Bandkabel sind in der Mitte soweit längs geschlitzt, damit sich genügend lange Enden zum Anschluß auf den Buchsenleisten der Koppelmatrizen GU1 bzw. GU2 ergeben.

In der gleichen Weise sind über jeweils zwei Bandkabel die weiteren Ausgänge der Koppelfelder KF1 und KF2 mit den zugehörigen Koppelmatrizen GU3 bis GU32 verbunden.

Die Anwendung von Bandkabel wird durch die anhand der Figur 13 erläuterten Zuordnung von jeweils acht Ausgängen der Koppelfelder KF1 und KF2 zu jeweils den Eingängen A1 bis A8 oder A9 bis A16 einer der Koppelmatrizen GU1 bis GU32 ermöglicht. Durch die Verwendung der Bandkabel wird erreicht, daß diese Verbindungen elektrische Eigenschaften mit geringen Exemplarstreuungen aufweisen und damit für die Übertragung von Digitalsignalen mit hoher Bitrate geeignet sind.

## Patentansprüche

1. Dreistufige Koppelanordnung in Raumvielfachtechnik für die elektrische Nachrichtenvermittlungstechnik mit einer ersten, einer zweiten und einer dritten Stufe, wobei jede Stufe aus mehreren Koppelmatrizen besteht und die Ausgänge der Koppelmatrizen einer Stufe über Zwischenleitungen mit den Eingängen der Koppelmatrizen der nächsten Stufe verbunden sind und wobei die Eingänge der Koppelmatrizen der ersten Stufe die Eingänge der Koppelanordnung und die Ausgänge der Koppelmatrizen der dritten Stufe die Ausgänge der Koppelanordnung bilden, mit folgenden Merkmalen:

   a) Die Koppelmatrizen (G1 ... G16) sind auf zwei gleiche dreistufige Koppelfelder (KF1, KF2) verteilt.

   b) Jede Stufe (M1, M2, M3) eines jeden Koppelfeldes (KF1 bzw. KF2) weist die gleiche Zahl von Koppelmatrizen (G1 ... G16) auf.

   c) Die Zahl der Eingänge (E1 ... E16) einer jeden Koppelmatrix ist gleich der Zahl ihrer Ausgänge (A1 ... A16).

   d) Jeder der Eingänge (E1 ... E16) der Koppelmatrizen (G1 ... G16) der ersten Stufe (M1) im jeweiligen

<div align="center">7</div>

Koppelfeld (KF1 bzw. KF2) bildet einen der Eingänge (E001 ... E256) des betreffenden Koppelfeldes (KF1 bzw. KF2).

Jeder der Ausgänge (A1 ... A16) der Koppelmatrizen (G1 ... G16) der dritten stufe (M3) im jeweiligen Koppelfeld (KF1 bzw. KF2) bildet einen der Ausgänge (A001 ... A256) des betreffenden Koppelfeldes (KF1 bzw. KF2).

f) Ein jeder Eingang (E001 ... E256) des ersten Koppelfeldes (KF1) ist mit dem gleichnamigen Eingang (E001 ... E256) des zweiten Koppelfeldes (KF2) verbunden.

g) Ein jeder Ausgang (A001 ... A256) des ersten Koppelfeldes (KF1) ist mit dem gleichnamigen Ausgang (A001 ... A256) des zweiten Koppelfeldes (KF2) verbunden.

h) Es ist eine beiden Koppelfeldern (KF1, KF2) gemeinsame Steuerung (St) vorgesehen, gekennzeichent durch folgende Merkmale:

    h1) Die Leitungen für die den durchzuschaltenden Koppelpunkt kennzeichnenden Adressen (Sp.-A., Z.-A., Km.-A., St.-A.) führen von der Steuerung (St) parallel zu den beiden Koppelfeldern (KF1, KF2).

    h2) Es sind zwei individuell von zwei Ausgängen der Steuerung (St) für die Schrankadressen (Schr.-A.1 bzw Schr.-A.2) zu den jeweiligen Eingängen (Schr.-A.) der Koppelfelder (KF1 bzw. KF2) geführte Leitungen vorgesehen.

i) Jedes Koppelfeld (KF1 bzw. KF2) ist folgendermaßen aufgebaut:

    i1) Jede Koppelmatrix (G1 ... G16) ist als Steckbaugruppe (G1 ... G16, Fig. 6) ausgeführt, welche an einer Kante Steckverbinder (S1, S2) zum Herausführen von Eingängen (E1 ... E16) und Ausgängen (A1 ... A16) trägt.

    i2) Die Koppelmatrizen bzw. Steckbaugruppen (G1 ... G16) einer Stufe sind in einem einzigen Magazin (M1, M2 bzw. M3, Fig. 5) zusammengefaßt.

    i3) Die Magazine (M1, M2, M3) sind so angeordnet, daß die Magazine von zwei aufeinanderfolgenden Stufen (M1 und M2 bzw. M2 und M3) unmittelbar benachbart sind.

    i4) Die Ein- und Ausgänge (E1 ... E16, A1 ... A16) der Koppelmatrizen (G1 ... G16) sind so auf den oder die Steckverbinder (S1, S2) verteilt, daß sie demjenigen Magazin (M1, M2 bzw. M3) zugewandt sind, mit dem sie über die Zwischenleitungen verbunden sind.

    i5) Es ist eine erste Rückwandleiterplatte (L1) zur Führung der Zwischenleitungen zwischen dem ersten und zweiten Magazin (M1, M2) vorgesehen.

    i6) Es ist eine zweite Rückwandleiterplatte (L2) zur Führung der Zwischenleitungen zwischen dem zweiten und dritten Magazin (M2, M3) vorgesehen.

    i7) Jede der Rückwandleiterplatten (L1 bzw. L2) trägt eine erste und eine zweite Reihe von Gegensteckverbindern (B1 ... B16 bzw. B17 ... B32).

    i8) Die Rückwandleiterplatten (L1, L2) und die Gegensteckverbinder (B1 ... B32) sind so angebracht, daß in die erste Reihe von Gegensteckverbinder (B1 ... B16) die Steckverbinder (S2) oder die Teile der Steckverbinder der Steckbaugruppen (G1 ... G16) eines Magazins (M1 bzw. M2) eingreifen, welche die Ausgänge (A1 ... A16) der betreffenden Steckbaugruppen tragen und in die zweite Reihe von Gegensteckverbindern (B17 ... B32) die Steckverbinder (S1) oder die Teile der Steckverbinder der Steckbaugruppen (G1 ... G16) des nächsten Magazins (M2 bzw. M3) eingreifen, welche die Eingänge (E1 ... E16) der betreffenden Steckbaugruppe (G1 ... G16) tragen.

**2.** Koppelanordnung nach Anspruch 1, gekennzeichnet durch folgende Merkmale:

    a) Die Rückwandleiterplatten (L1, L2) sind in Multilayer-Technik ausgeführt.

    b) In verschiedenen Ebenen der Rückwandleiterplatte parallel laufende Leiter oder Leiterpaare (LB1, LB2, LB3) sind gegenseitig versetzt.

    c) Die Weite der Versetzung und die Zahl der Ebenen, über die sie sich erstreckt sind so bemessen, daß die geforderten Nebensprechdämpfungswerte zwischen den Leitern bzw. Leiterbahnen eingehalten werden (Fig. 10).

    d) Spitzwinklige und rechtwinklige Leiterbahnabknickungen sind entweder abgerundet ausgeführt oder in mehrere stumpfwinklige Abknickungen aufgelöst (Fig. 7, 8, 9).

    e) Die Verbindung der Eingänge (E001 ... E256) der beiden Koppelfelder (KF1 und KF2) untereinander und mit den Signalquellen (Q) ist folgendermaßen ausgeführt:

        e1) Die Signalquellen sind mit den Eingängen (E001 ... E256) des einen Koppelfeldes (KF1 oder KF2) verbunden (Fig. 11).

        e2) Von diesen Eingängen führt eine Parallelverkabelung (P1) zu den Eingängen (E001 ... E256) des anderen Koppelfeldes (KF2 bzw. KF1).

        e3) An jedem Eingang dieses anderen Koppelfeldes ist ein Abschlußwiderstand (R) angeschlossen.

f) Die Verbindung der Ausgänge (A001 ... A256) der beiden Koppelfelder (KF1 und KF2) untereinander und mit den Signalsenken (S) ist folgendermaßen ausgeführt:

f1) Es sind soviele elektronische Umschalter (U001 ... U256) vorgesehen wie ein Koppelfeld (KF1 oder KF2) Ausgänge (A001 ... A256) aufweist (Fig. 12).

f2) Jeder elektronische Umschalter (U001 ... U256) weist einen ersten und einen zweiten Eingang sowie einen Ausgang und einen Steuereingang auf.

f3) Der erste Eingang eines jeden elektronischen Umschalters ist mit dem zugehörigen Ausgang des ersten Koppelfeldes (KF1) verbunden.

f4) Der zweite Eingang eines jeden elektronischen Umschalters ist mit dem zugehörigen Ausgang des zweiten Koppelfeldes (KF2) verbunden.

f5) Die Ausgänge der elektronischen Umschalter sind mit den Signalsenken (S) verbunden.

f6) Die Steuereingänge der elektronischen Umschalter sind mit einer Umschalt-Steuerung (U.-St.) verbunden, so daß jeder elektronische Umschalter (U001 ... U256) durch eine Einstellinformation in seine erste oder zweite Schaltstellung steuerbar ist.

f7) In der ersten Schaltstellung ist der jeweilige Ausgang (A001 ... A256) des ersten Koppelfeldes (KF1) zur jeweiligen Signalsenke (S) durchgeschaltet.

f8) In der zweiten Schaltstellung ist der jeweilige Ausgang des zweiten Koppelfeldes (KF2) zur jeweiligen Signalsenke (S) durchgeschaltet.

f9) Die Umschaltsteuerung (U.-St.) ist mit den Ausgängen für die den durchzuschaltenden Koppelpunkt markierenden Adressen (Sp.-A., Z.-A., Km.-A., St.-A.) sowie mit den Ausgängen für die Schrankadressen (Schr.-A1, Schr.-A2) der Steuerung (St) verbunden.

f10) Die Umschaltsteuerung (U.-St.) ist so gestaltet, daß der jeweilige elektronische Umschalter in die erste bzw. zweite Schaltstellung versetzt wird, je nach dem die durchzuschaltende Verbindung über das erste oder zweite Koppelfeld (KF1 zw. KF2) geführt wird.

## Claims

1. A three-stage switching arrangement in space-division technology for electrical data exchange systems including a first stage, a second stage and a third stage; wherein each stage is composed of a plurality of switching matrixes; the outputs of the switching matrixes of one stage are connected with the inputs of the switching matrixes of the next stage via intermediate lines; the inputs of the switching matrixes of the first stage constitute the inputs of the switching arrangement and the outputs of the switching matrixes of the third stage constitute the outputs of the switching arrangement, with the following features:

(a) the switching matrixes (G1, ..., G16) are distributed to two identical three-stage switching arrays (KF1, KF2);

(b) each stage (M1, M2, M3) of each switching array (KF1, KF2) has the same number of switching matrixes (G1, ..., G16);

(c) the number of inputs (E1, ..., E16) of each switching matrix is equal to the number of its outputs (A1, ..., A16);

(d) each one of the inputs (E1, ..., E16) of the switching matrixes (G1, ..., G16) of the first stage (M1) in the respective switching array (KF1, KF2) constitutes one of the inputs (E001, ..., E256) of the respective switching array (KF1, KF2);

(e) each one of the outputs (A1, ..., A16) of the switching matrixes (G1, ..., G16) of the third stage (M3) in the respective switching array (KF1, KF2) constitutes one of the outputs (A001, ..., A256) of the respective switching array (KF1, KF2);

(f) each input (E001, ..., E256) of the first switching array (KF1) is connected with the identically numbered input (E001, ..., E256) of the second switching array (KF2);

(g) each output (A001, ..., A256) of the first switching array (KF1) is connected with the identically numbered output (A001, ..., A256) of the second switching array (KF2);

(h) a control (St) is provided which is common to both switching arrays (KF1, KF2) <u>characterised by</u> the following features:

(h1) the lines for the addresses (Sp.-A., Z.-A., Km.-A., St.-A.) identifying the crosspoint to be switched through lead from the control (St) in parallel to both switching arrays (KF1, KF2);

(h2) two individual lines are provided which lead from the two outputs of the control (St) for the switchboard addresses (Schr.-A.1, Schr.-A.2) to the respective inputs (Schr.-A.) of the switching arrays (KF1, KF2).

(i) each switching array (KF1, KF2) is constructed as follows:

9

(i1) each switching matrix (G1, ..., G16) is configured as a multi-point connector module (G1, ..., G16, Figure 6) which is provided, at one of its edges, with multipoint connectors (S1, S2) to connect to the inputs (E1, .... E16) and the outputs (A1, ..., A16);

(i2) the switching matrixes and multi-point connector modules, respectively, (G1, ..., G16) of one stage are combined in a single magazine (M1, M2, M3, Figure 5);

(i3) the magazines (M1, M2, M3) are arranged in such a manner that the magazines of two successive stages (M1 and M2 as well as M2 and M3) are immediately adjacent one another;

(i4) the inputs and outputs (E1, ..., E16, A1, ..., A16) of the switching matrixes (G1, ..., G16) are distributed to the connector(s) (S1, S2) in such a manner that they face that magazine (M1, M2, M3) with which they are connected by way of intermediate lines;

(i5) a first rear wall circuit board (L1) is provided to guide the intermediate lines between the first and the second magazines (M1, M2);

(i6) a second rear wall circuit board (L2) is provided to guide the intermediate lines between the second and the third magazines (M2, M3);

(i7) each one of the rear wall circuit boards (L1, L2) is provided with a first row and a second row of socket connectors (B1, ..., B16; B17, ..., B32);

(i8) the rear wall circuit boards (L1, L2) and the socket connectors (B1, ..., B32) are attached in such a manner that the first row of socket connectors (B1, .... B16) engage the connectors (S2) or parts of the connectors of those multi-point connector modules (G1, ..., G16) of a magazine (M1, M2) which carry the outputs (A1, ..., A16) of the respective multi-point connector modules and the second row of socket connectors (B17, ..., B32) engage those connectors (S1) or parts of the connectors of the multi-point connector modules (G1, ..., G16) of the next magazine (M2, M3) which carry the inputs (E1, ..., E16) of the respective multi-point connector modules (G1, ..., G16).

2. A switching arrangement according to claim 1, <u>characterised by</u> the following features:

(a) the rear wall circuit boards (L1, L2) are constructed in multilayer technology;

(b) conductors or pairs of conductors (LB1, LB2, LB3) extending in parallel in different planes of the rear wall circuit board are mutually offset;

(c) the width of the offset and the number of planes over which it extends are dimensioned so as to maintain the required crosstalk attenuation values between the conductors or conductor paths (Figure 10);

(d) bends in the conductor paths at an acute or right angle are either rounded off or are resolved into a plurality of obtuse angle bends (Figures 7, 8, 9);

(e) the connection of the inputs (E001, ..., E256) of the two switching arrays (KF1 and KF2) with one another and with the signal sources (Q) are made as follows:

(e1) the signal sources are connected with the inputs (E001, ..., E256) of the one switching array (KF1 or KF2) (Figure 11);

(e2) from these inputs, a parallel wire (P1) leads to the inputs (E001, ..., E256) of the other switching array (KF2 or KF1);

(e3) each input of this other switching array is connected with a terminating resistance (R);

(f) the connection of the outputs (A001, ..., A256) of the two switching arrays (KF1 and KF2) with one another and with the signal drains (S) are made as follows:

(f1) as many electronic switches (U001, ..., U256) are provided as a switching array (KF1 or KF2) has outputs (A001, ..., A256) (Figure 12);

(f2) each electronic switch (U001, ..., U256) has a first input and a second input as well as an output and a control input;

(f3) the first input of each electronic switch is connected with the associated output of the first switching array (KF1);

(f4) the second input of each electronic switch is connected with the associated output of the second switching array (KF2);

(f5) the outputs of the electronic switches are connected with the signal drains (S);

(f6) the control inputs of the electronic switches are connected with a switch control (U.-St.) so that each electronic switch (U001, ..., U256) can be controlled into its first switch position or into its second switch position by means of a setting information;

(f7) in the first switch position, the respective output (A001, ..., A256) of the first switching array (KF1) is switched through to the respective signal drain (S);

(f8) in the second switch position, the respective output of the second switching array (KF2) is switched through to the respective signal drain (S);

(f9) the switch control (U.-St.) is connected with the outputs for the addresses (Sp.-A., Z.-A., Km.-A., St.-A.) marking the crosspoint to be switched through and with the outputs for the switchboard addresses (Schr. -A1, Schr.-A2) of the control (St);

(f10) the switch control (U.-St.) is configured in such a manner that the respective electronic switch is moved into its first or second switch position, respectively, depending on whether the connection to be switched through is made by way of the first switching array or by way of the second switching array (KF1,or KF2, respectively).

## Revendications

1. Dispositif de couplage à trois étages et à multiplexage spatial pour la commutation électrique de messages possédant un premier, un second et un troisième étages, chaque étage se composant de plusieurs matrices de couplage et les sorties des matrices de couplage de l'un des étage étant reliées par des liaisons intermédiaires aux entrées des matrices de couplages de l'étage suivant, où les entrées des matrices de couplage du premier étage constituent les entrées du dispositif de couplage et les sorties des matrices de couplage du troisième étage les sorties du dispositif de couplage, avec les éléments suivants :

a) Les matrices de couplage (G1 à G16) sont distribuées entre deux champs de couplage (KF1, KF2) identiques à trois étages.

b) Chacun des étages (M1, M2, M3) de chacun des champs de couplage (KF1, KF2) possède le même nombre de matrices de couplage (G1 à G16).

c) Le nombre des entrées (E1 à E16) de chacune des matrices de couplage est identique au nombre des sorties (A1 à A16).

d) Chacune des entrées (E1 à E16) des matrices de couplage (G1 à G16) du premier étage (M1) d'un des champs de couplage (KF1, KF2) constitue l'une des entrées (E001 à E256) du champ de couplage considéré (KF1 ou KF2).

e) Chacune des sorties (A1 à A16) des matrices de couplage (G1 à G16) du troisième étage (M3) d'un des champs de couplage (KF1, KF2) constitue l'une des sorties (A001 à A256) du champ de couplage considéré (KF1 ou KF2).

f) Chacune des entrées (E001 à E256) du premier champ de couplage (KF1) est reliée à l'entrée de même nom (E001 à E256) du second champ de couplage (KF2).

g) Chacune des sorties (A001 à A256) du premier champ de couplage (KF1) est reliée à la sortie de même nom (A001 à A256) du second champ de couplage (KF2).

h) Il est prévu une commande (St) commune aux deux champs de couplage (KF1, KF2) caractérisé par les éléments suivants :

h1) Les lignes d'adressage identifiant le point de couplage à commuter (Sp.-A., Z.-A., Km.-A., St.-A.) sont posées en parallèle entre la commande (St) et les deux champs de couplage (KF1, KF2).

h2) Il est prévu deux lignes individuelles menant des deux sorties de la commande (St) affectées aux adresses des armoires (Schr.-A.1 et Schr.-A.2) aux entrées correspondantes (Schr.-A.) des champs de couplage (KF1, KF2).

i) chacun des champs de couplage (KF1, KF2) est construit de la manière suivante :

i1) Chaque matrice de couplage (G1 à G16) est réalisée sous la forme d'un module enfichable (G1 à G16, figure 6) portant sur l'une de ses arêtes des connecteurs (S1, S2) correspondant aux entrées (E1 à E16) et aux sorties (A1 à A16).

i2) Les matrices de couplage ou modules enfichables (G1 à G16) d'un des étages sont réunis en un seul magasin (M1, M2, M3, figure 5).

i3) Les magasins (M1, M2, M3) sont disposés de manière à ce que les magasins de deux étages successifs (M1 et M2 ou M2 et M3) soient immédiatement adjacents.

i4) Les entrées et sorties (E1 à E16 et A1 à A16) des matrices de couplage (G1 à G16) sont distribuées entre les connecteurs de manière à être tournées vers le magasin (M1, M2 et M3) avec lequel elles sont reliées par des liaisons intermédiaires.

i5) Il est prévu une première carte de fond de panier (L1) regroupant les liaisons intermédiaires entre le premier et le second magasins (M1, M2).

i6) Il est prévu une seconde carte de fond de panier (L2) regroupant les liaisons intermédiaires entre le second et le troisième magasins (M2, M3).

i7) Chacune des cartes de fond de panier (L1, L2) porte une première et une seconde rangée de connecteurs (B1 à B16 et B17 à B32).

i8) Les cartes de fond de panier (L1, L2) et les connecteurs (B1 à B32) sont disposés de manière à ce que la première rangée de connecteurs (B1 à B16) reçoivent les connecteurs (S2) ou les parties des connecteurs uniques des modules enfichables (G1 à G16) d'un magasin (M1 ou M2) qui portent les sorties (A1 à A16) du module enfichable considéré et à ce que la seconde rangée de connecteurs (B17 à B32) reçoive les connecteurs (S1) ou les parties des connecteurs uniques des modules enfichables (G1 à G16) du magasin suivant (M2 ou M3) qui portent les entrées (E1 à E16) du module enfichable considéré (G1 à G16).

2.   Dispositif de couplage selon la revendication 1, caractérisé par les éléments suivants :
   a) Les cartes de fond de panier (L1, L2) sont réalisées en technique multicouche.
   b) Les conducteurs ou paires de conducteurs (LB1, LB2, LB3) placés à des niveaux différents de la carte de fond de panier sont décalés les uns par rapport aux autres.
   c) L'ampleur du décalage et le nombre des plans sur lesquels il s'étend sont déterminés de manière à ce que les valeurs exigées d'affaiblissement diaphonique soient respectées entre les conducteurs ou les pistes conductrices (figure 10).
   d) Les coudes aigus ou droits des pistes conductrices sont soit arrondis soit décomposés en plusieurs coudes obtus (figures 7, 8 et 9).
   e) La liaison des entrées (E001 à E256) des deux champs de couplage (KF1, KF2) entre elles et avec les sources de signal (Q) est réalisée de la manière suivante :
      e1) Les sources de signal sont reliées aux entrées (E001 à E256) du premier champ de couplage (KF1 ou KF2) (figure 11).
      e2) A partir de ces entrées, un câblage parallèle (P1) mène aux entrées (E001 à E256) de l'autre champ de couplage (KF2 ou KF1).
      e3) A chaque entrée de cet autre champ de couplage est raccordée une résistance de terminaison (R).
   f) La liaison des sorties (A001 à A256) des deux champs de couplage (KF1, KF2) entre elles et avec les consommateurs de signal (S) est réalisée de la manière suivante :
      f1) Il est prévu un nombre de commutateurs électroniques (U001 à U256) correspondant au nombre des sorties d'un des champs de couplage (KF1 ou KF2) (figure 12).
      f2) Chacun des commutateurs électroniques (U001 à U256) possède une première et une seconde entrées, ainsi qu'une sortie et une entrée de commande.
      f3) La première entrée de chaque commutateur électronique est reliée à la sortie correspondante du premier champ de couplage (KF1).
      f4) La seconde entrée de chaque commutateur électronique est reliée à la sortie correspondante du second champ de couplage (KF2).
      f5) Les sorties des commutateurs électroniques sont reliées aux consommateurs de signal (S).
      f6) Les entrées de commandes des commutateurs électroniques sont reliées à une commande de commutation (U.-St.) de manière à ce que chacun des commutateurs électroniques (U001 à U256) puisse être commuté dans une information de positionnement dans sa première ou sa seconde position de commutation.
      f7) Dans la première position de commutation, la sortie (A001 à 256) considérée du premier champ de couplage (KF1) est reliée au consommateur de signal considéré (S).
      f8) Dans la seconde position de commutation, la sortie considérée du second champ de couplage (KF2) est reliée au consommateur de signal considéré (S).
      f9) La commande de commutation (U.-St.) est reliée aux sorties de la commande (St) affectées à l'adressage du point de couplage à commuter (Sp.-A., Z.-A., Km.-A., St.-A.) et aux sorties des adresses d'armoire (Schr.-A.1, Schr.-A.2).
      f10) La commande de commutation (U.-St.) est conçue de manière à ce que le commutateur électronique considéré soit placé dans la première ou la seconde position de commutation suivant que la liaison à commuter passe par le premier ou le second champ de couplage (KF1 ou KF2).

FIG. 1

EP 0 240 580 B2

FIG.2

FIG. 3

EP 0 240 580 B2

FIG. 4

FIG.5

FIG. 6

FIG.7

FIG. 8

**B12**  **B13**  **B14**  **B15**  **B16**

**B28**  **B29**  **B30**  **B31**  **B32**

FIG. 9

FIG. 10

FIG. 11

EP 0 240 580 B2

FIG. 12

FIG. 13

KF1  KF2

M1  M1
M2  M2
M3  M3
M4  M4

GU1 · · · · · GU16  GU17  GU32

FIG. 14

EP 0 240 580 B2

A001
A016
B49
(KF1)

A001
A016
B49
(KF2)

BK1

BK2

E1
E16

GU1  GU2

FIG. 15

EP 0 240 580 B2